# EUROPEAN PATENT APPLICATION

(11) **EP 1 458 059 A1**
(43) Date of publication of application: **15.09.2004**
(21) Application number: 03251541.3
(22) Date of filing: 13.03.2003
(51) Int. Cl.: H01R 13/645, H01R 12/38, H01R 12/08

(54) **Connecting device for connecting electrically a flexible printed board to a circuit board**

(71) Applicant: Peng, Fred, Ping-Chen-City, Tao-Yuan Hsien (TW)
(72) Inventor: Peng, Fred, Ping-Chen-City, Tao-Yuan Hsien (TW)
(74) Representative: Godwin, Edgar James

(57) **Abstract**

A connecting device includes a plurality of resilient terminal pieces (1), each of which has a connecting end portion (11) connected electrically to a corresponding one of conductive contacts (313) on a flexible printed board (3), and a resilient contact end portion (12) opposite to the connecting end portion (11). A positioning unit (2) is provided on the flexible printed board (3) and a circuit board (4) for positioning the flexible printed board (3) on the circuit board (4) so as to enable the contact end portion (12) of each of the terminal pieces (1) to contact electrically a corresponding one of contact pads (41) on the circuit board (4). As such, each of the contact pads (41) can be connected a respective one of the conductive contacts (313) on the flexible printed board (3).

## Description

The invention relates to a connecting device, more particularly to a connecting device for connecting electrically a flexible printed board to a circuit board.

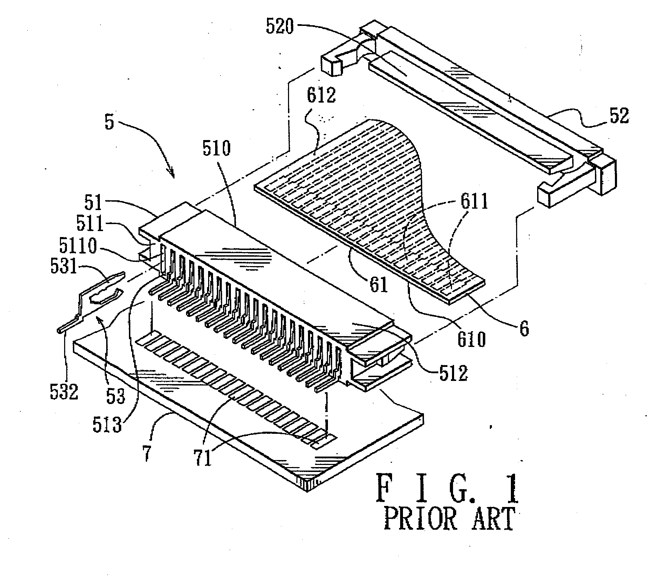

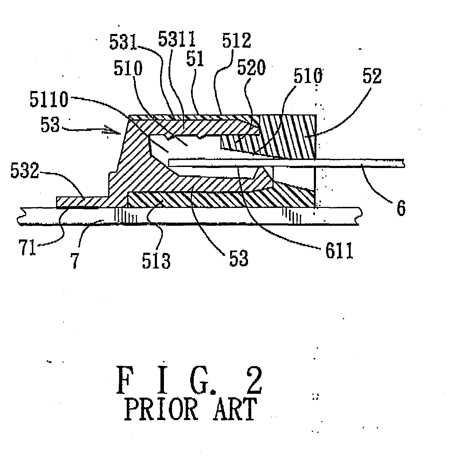

Figure 1 illustrates a conventional connecting device 5 for connecting electrically a flexible printed board 6 to a circuit board 7. The flexible printed board 6 has an end portion 61 that has a first surface 610 formed with a plurality of conductive contacts 611 thereon, and a second surface 612 opposite to the first surface 610. The circuit board 7 is formed with a plurality of contact pads 71 thereon, each of which corresponds to a respective one of the conductive contacts 611. The conventional connecting device 5 includes a housing 51, which is made of an insulating material, mounted on the circuit board 7 adjacent to the contact pads 71, a connecting block 52, and a plurality of terminal pieces 53. The housing 51 has a front end 511 and a rear open end 510. The front end 511 is formed with a plurality of terminal grooves 5110, each of which corresponds to a respective one of the contact pads 71 on the circuit board 7 and is communicated with the rear open end 510. The housing 51 further has a top wall 512, and a bottom wall 513 mounted on the circuit board 7. The connecting block 52 is mounted on the housing 51 at the rear open end 510, and has a tongue portion 520 that extends into the housing 51 via the rear open end 510. Each terminal piece 53 has a connecting portion 532 welded to a corresponding one of the contact pads 71, and a clamping portion 531 extending into a corresponding one of the terminal grooves 5110. The clamping portion 531 of each terminal piece 53 has an upper segment 5311 abutting against the top wall 512 of the housing 51 and retained between the top wall 512 of the housing 51 and the tongue portion 520 of the connecting block 52, and a lower segment 5312 abutting against the bottom wall 513, as shown in Figure 2. As such, when the end portion 61 of the flexible printed board 6 is extended into the housing 51 via the rear open end 510, the end portion 61 of the flexible printed board 6 is retained between the connecting block 52 and the lower segments 5312 of the clamping portions 531 of the terminal pieces 53 such that the lower segment 5312 of the clamping portion 531 of each terminal piece 53 contacts electrically a corresponding one of the conductive contacts 611 on the flexible printed board 6. Therefore, electrical connection between the flexible printed board 6 and the circuit board 7 can be achieved using the conventional connecting device 5.

Since the conventional connecting device 5 must be designed for application to a flexible printed board and a circuit board with specific specifications, such as size and number of the terminals, specific molds for the housing 51 and the connecting block 52 are necessary and result in relatively high costs. Furthermore, the connecting portion 532 of each terminal piece 53 must be welded exactly on the corresponding one of the contact pads 71 on the circuit board 7, thereby resulting in a relatively complex fabrication process. Besides, since the conductive contacts 611 on the flexible printed board 6 are disposed inside the housing 51, it is necessary to remove the flexible printed board 6 from the housing 5 when inspecting circuit connect ions. This can result in damage to the flexible printed board 6.

Therefore, the object of the present invention is to provide a connecting device which can be used for connecting electrically a flexible printed board to a circuit board and which is free of the aforesaid drawbacks of the prior art.

According to one aspect of the present invention, a connecting device is used for connecting electrically a flexible printed board to a circuit board. The flexible printed board has an end portion formed with apluralityof conductive contacts thereon. The circuit board is formed with a plurality of contact pads thereon, each of which corresponds to a respective one of the conductive contacts. The connecting device comprises:
a plurality of resilient terminal pieces, each of which has a connecting end portion adapted to be connected electrically to a corresponding one of the conductive contacts on the flexible printed board, and a resilient contact end portion opposite to the connecting end portion; and
a positioning unit adapted to be provided on the flexible printed board and the circuit board for positioning the flexible printed board on the circuit board so as to enable the contact end portion of each of the terminal pieces to contact electrically a corresponding one of the contact pads on the circuit board.

According to another aspect of the present invention, a circuit assembly comprises:
a flexible printed board having an end portion formed with a plurality of conductive contacts thereon;
a circuit board formed with a plurality of contact pads thereon, each of which corresponds to a respective one of the conductive contacts; and
a connecting device including
   a plurality of resilient terminal pieces, each of which has a connecting end portion connected electrically to a corresponding one of the conductive contacts on the flexible printed board, and a resilient contact end portion opposite to the connecting end portion, and
   a positioning unit provided on the flexible printed board and the circuit board for positioning the flexible printed board on the circuit board so as to enable the contact end portion of each of the terminal pieces to contact electrically a corresponding one of the contact pads on the circuit board.

Other features and advantages of the present invention will become apparent in the following detailed description of the preferred embodiments with reference to the accompanying drawings, of which:
Figure 1 is an exploded perspective view showing a conventional connecting device for connecting a flexible printed board to a circuit board;
Figure 2 is a schematic sectional view showing the conventional connecting device of Figure 1 in a state of use;
Figure 3 is an exploded fragmentary perspective view showing the first preferred embodiment of a circuit assembly according to the present invention;
Figure 4 is a fragmentary schematic side view showing a positioning unit of the first preferred embodiment;
Figure 5 is a schematic side view illustrating how a flexible printed board is connected electrically to a circuit board via a resilient terminal piece in the first preferred embodiment;
Figure 6 is an exploded fragmentary perspective view showing the second preferred embodiment of a circuit assembly according to the present invention;
Figure 7 is a schematic side view showing a positioning unit assembled on a flexible printed board and a circuit board of the second preferred embodiment;
Figure 8 is a schematic side view showing a hot-melt adhesive layer between the flexible printed board and the circuit board in the second preferred embodiment;
Figure 9 is an exploded fragmentary perspective view showing the third preferred embodiment of a circuit assembly according to the present invention; and
Figure 10 is a schematic partly sectional view showing the third preferred embodiment.

Before the present invention is described in greater detail, it should be noted that like elements are denoted by the same reference numerals throughout the disclosure.

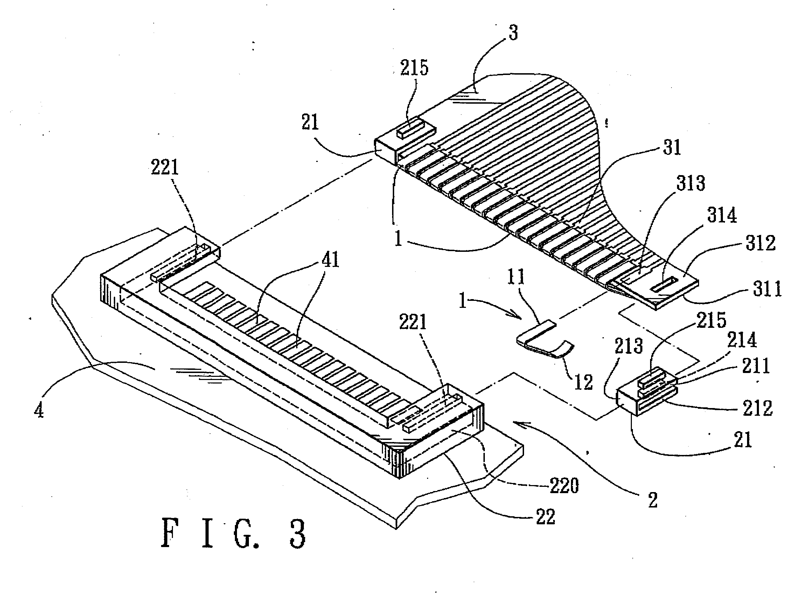

Referring to Figures 3 to 5, the first preferred embodiment of a circuit assembly according to the present invention is shown to include a flexible printed board 3, a circuit board 4, and a connecting device.

The circuit board 4 is formed with a plurality of contact pads 41 thereon.

The flexible printed board 3 has an end portion 31 that has a first surface 311 facing the circuit board 4, and a second surface 312 opposite to the first surface 311 and formed with a plurality of conductive contacts 313 thereon, each of which corresponds to a respective one of the contact pads 41 on the circuit board 4.

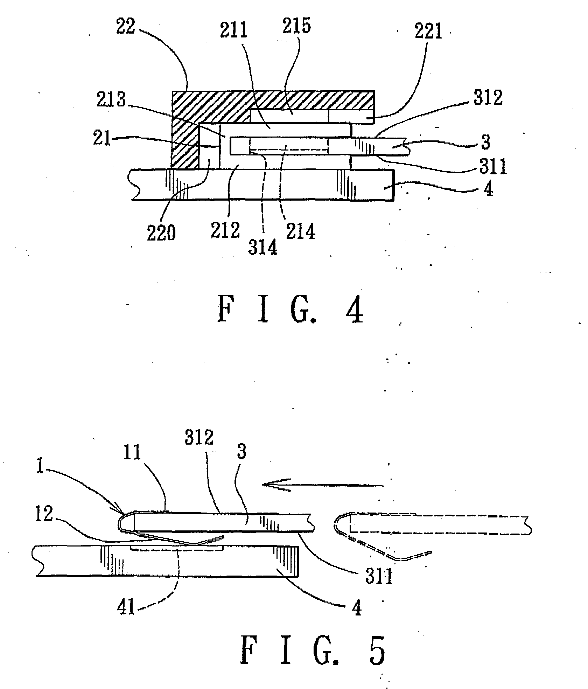

The connecting device includes a plurality of resilient terminal pieces 1, and a positioning unit 2. Each terminal piece 1 has a connecting end portion 11 connected electrically to a corresponding one of the conductive contacts 313 on the second surface 312 of the flexible printed board 3, such as by welding, and a resilient contact end portion 12 opposite to the connecting end portion 11 and disposed between the first surface 311 of the end portion 31 of the flexible printed board 3 and the circuit board 4, as shown in Figure 5. It is noted that the resilient terminal pieces 1 can be formed simultaneously via a punching process.

The positioning unit 2 is provided on the flexible printed board 3 and the circuit board 4 for positioning the flexible printed board 3 on the circuit board 4 so as to enable the contact end portion 12 of each of the terminal pieces 1 to contact electrically a corresponding one of the contact pads 41 on the circuit board 4. In this embodiment, the positioning unit 2 includes a pair of mounting blocks 21, which are made of plastic material, mounted on the end portion 31 of the flexible printed board 3, and a connecting seat unit 22 mounted fixedly on the circuit board 4 and formed with a pair of receiving recesses 220 for receiving the mounting blocks 21. Each of the mounting blocks 21 has parallel upper and lower plate portions 211, 212 spaced apart from each other, an intermediate plate portion 213 interconnecting the upper and lower plate portions 211, 212, and an engaging rib 214 projecting from the upper plate portion 211 toward the lower plate portion 212, as best shown in Figure 4. The engaging rib 214 of each of the mounting blocks 21 engages a respective one of two engaging holes 314 formed in the end portion 31 of the flexible printed board 3 . Each of the mounting blocks 21 further has a positioning key 215 provided on the upper plate portion 211 thereof. The connecting seat unit 22 is further formed with a positioning keyway 221 in each of the receiving recesses 220. Each of the positioning keys 215 slidably engages the positioning keyway 221 in the respective one of the receiving recesses 220.

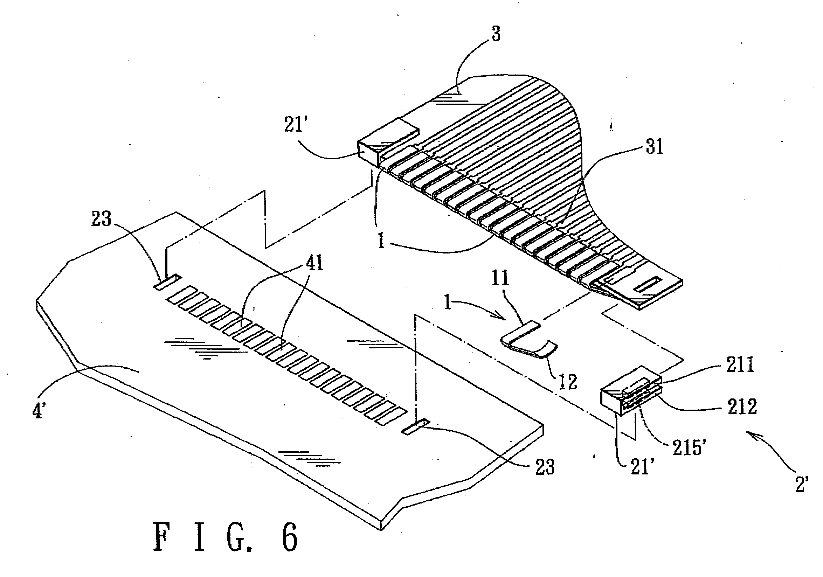

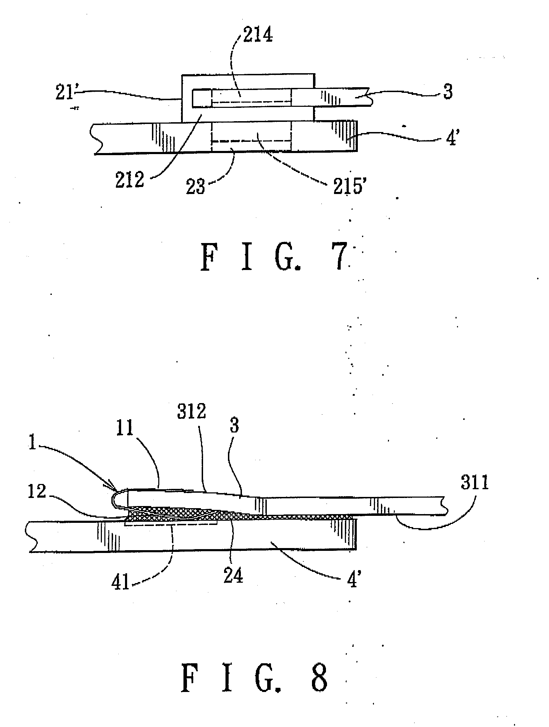

Figures 6 to 8 illustrate the second preferred embodiment of a circuit assembly according to the present invention, whichisamodificationofthe first preferred embodiment. Unlike the previous embodiment, the positioning unit 2' includes apair of positioning blocks 21', which have the same construction as that of the mounting blocks 21 in the first preferred embodiment, mounted on the end portion 31 of the flexible printed board 3 and disposed on the circuit board 4' . Each of the positioning blocks 21' has a positioning rib 215' provided on the lower plate portion 212 and engaging a respective one of two positioning holes 23 formed in the circuit board 4' forpositioning the flexible printed board 3 on the circuit board 4' , as best shown in Figure 7. In this embodiment, the circuit assembly further includes a hot-melt adhesive layer 24 between the first surface 311 of the flexible printed board 3 and the circuit board 4' so as to maintain electrical contact between the contact end portions 12 of the terminal pieces 1 and the contact pads 41 on the circuit board 4'.

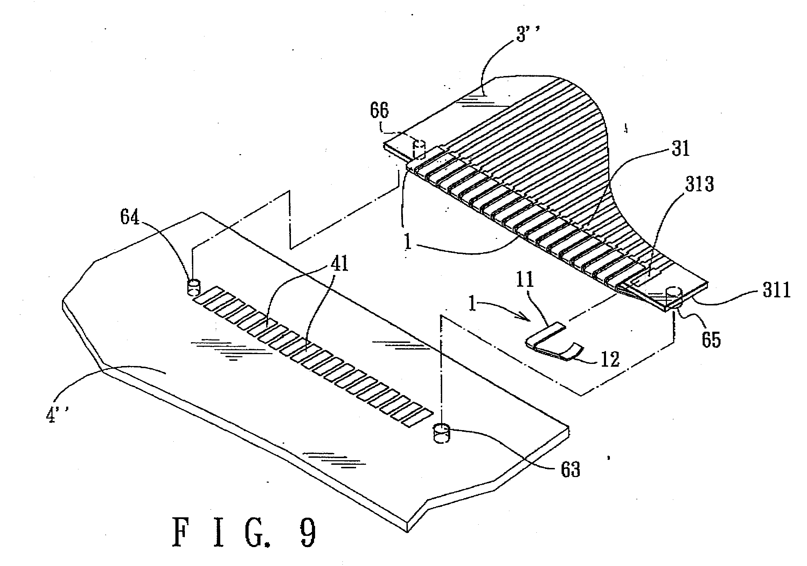

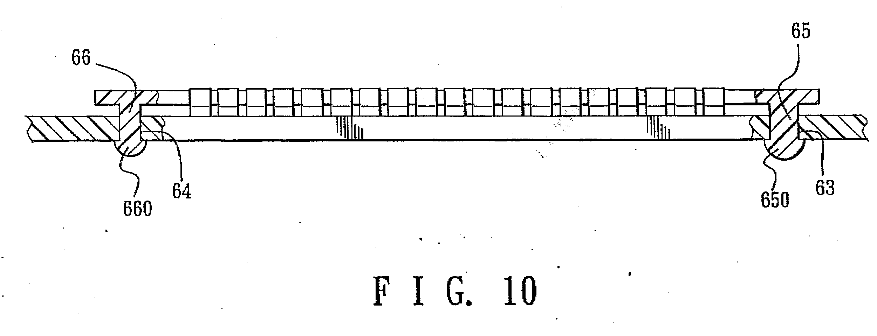

Figures 9 and 10 illustrate the third preferred embodiment of a circuit assembly according to the present invention, which is a modification of the second preferred embodiment. Unlike the previous embodiments, the positioning unit includes first and second positioning posts 65, 66 with different cross-sections and provided on the first surface 311 of the flexible printed board 3". The circuit board 4" is formed with first and second positioning holes 63, 64 that permit extension of a respective one of the first and second positioning posts 65, 66 therethrough. Each of the first and second positioning posts 65, 66 is formed with an enlarged end portion 650, 660 by a melting process after being extended through the respective one of the first and second positioning holes 63, 64. The enlarged end portion 650, 660 of each of the first and second positioning posts 65, 66 has a cross-section larger than that of the respective one of the first and second positioning holes 63, 64.

It is noted that the connecting device of this invention has a relatively simple construction and that the terminal pieces 1 can be formed simultaneously by a punching process. The connecting end portions 11 of the terminal pieces 1 can be welded simultaneously on the conductive contacts 313 of the flexible printed board 3, thereby resulting in lower costs and a simple fabrication process. Moreover, the conductive contacts 313 of the flexible printed board 3 are exposed after assembly so as to facilitate inspection of circuit connections. Due to the presence of the positioning unit, clamping of the flexible printed board 3 is not required so as to avoid the damage commonly encountered in the aforesaid prior art.

## Claims

1. A connecting device for connecting electrically a flexible printed board (3) to a circuit board, the flexible printed board (3) having an end portion (31) formed with a plurality of conductive contacts (313) thereon, the circuit board (4) being formed with a plurality of contact pads (41) thereon, each of which corresponds to a respective one of the conductive contacts (313), said connecting device **characterized by**:
a plurality of resilient terminal pieces (1), each of which has a connecting end portion (11) adapted to be connected electrically to a corresponding one of the conductive contacts (313) on the flexible printed board (3), and a resilient contact end portion (12) opposite to said connecting end portion (11); and
a positioning unit (2) adapted to be provided on the flexible printed board (3) and the circuit board (4) for positioning the flexible printed board (3) on the circuit board (4) so as to enable said contact endportion (12) of each of said terminal pieces (1) to contact electrically a corresponding one of the contact pads (41) on the circuit board (4).

2. The connecting device as claimed in Claim 1, the end portion (31) of the flexible printed board (3) having a first surface (311) facing the circuit board (4) , and a second surface (312) opposite to the first surface (311) and formed with the conductive contacts (313), **characterized in that** said contact end portions (12) of said terminal pieces (1) are adapted to be disposed between the first surface (311) of the flexible printed board (3) and the circuit board (4).

3. The connecting device as claimed in Claim 1, characteri zed in that said positioning unit (2) includes a pair of mounting blocks (21) adapted to be mounted on the end portion (31) of the flexible printed board (3) , and a connecting seat unit (22) adapted to be mounted fixedly on the circuit board (4) and formed with a pair of receiving recesses (220) for receiving said mounting blocks (21), respectively.

4. The connecting device as claimed in Claim 3, further **characterized in that** said connecting seat unit (22) is further formed with a positioning keyway (221) in each of said receiving recesses (220), each of said mounting blocks (21) having a positioning key (215) provided thereon and slidably engaging said positioning keyway (211) in the respective one of said receiving recesses (220).

5. The connecting device as claimed in Claim 4, further **characterized in that** each of said mounting blocks (21) has parallel upper and lower plate portions (211, 212) spaced apart from each other, an intermediate plate portion (213) interconnecting said upper and lower plate portions (211, 212) , and an engaging rib (214) projecting from one of said upper and lower plate portions (211, 212) toward the other one of said upper and lower plate portions (211, 212), said engaging rib (214) being adapted to engage an engaging hole (314) formed in the end portion (31) of the flexible printed board (3), said upper plate portion (211) of each of said mounting blocks (21) being provided with said positioning key (215).

6. The connecting device as claimed in Claim 1, **characterized in that** said positioning unit (2') includes a pair of positioning blocks (21') adapted to be mounted on the end portion (31) of the flexible printed board (3) and adapted to be disposed on the circuit board (4'), each of said positioning blocks (21') having a positioning rib (215') adapted to engage a positioning hole (23) formed in the circuit board (4') for positioning the flexible printed board (3) on the circuit board (4') .

7. A circuit assembly, **characterized by**:
a flexible printed board (3) having an end portion (31) formed with a plurality of conductive contacts (313) thereon;
a circuit board (4) formed with a plurality of contact pads (41) thereon, each of which corresponds to a respective one of said conductive contacts (313) ; and
a connecting device including
apluralityof resilient terminalpieces (1) , each of which has a connecting end portion (11) connected electrically to a corresponding one of said conductive contacts (313) on said flexible printed board (3), and a resilient contact end portion (12) opposite to said connecting end portion (11), and
a positioning unit (2) provided on said flexible printed board (3) and said circuit board (4) for positioning said flexible printed board (3) on said circuit board (4) so as to enable said contact end portion (12) of each of said terminal pieces (1) to contact electrically a corresponding one of said contact pads (41) on said circuit board (4).

8. The circuit assembly as claimed in Claim 7, **characterized in that** said connecting end portion (11) of each of said terminal pieces (1) is welded to the corresponding one of said conductive contacts (313).

9. The circuit assembly as claimed in Claim 7, **characterized in that** said end portion (31) of said flexible printed board (3) has a first surface facing said circuit board, and a second surface opposite to said first surface and formed with said conductive contacts, said contact end portions of said terminal pieces being disposed between said first surface of said end portion (31) of said flexible printed board (3) and said circuit board.

10. The circuit assembly as claimed in Claim 7, **characterized in that** saidpositioningunit (2) includes apairof mounting blocks (21) mounted on said end portion (31) of said flexible printed board (3) , and a connecting seat unit (22) mounted fixedly on said circuit board (4) and formed with a pair of receiving recesses (220) for receiving said mounting blocks (21) , respectively.

11. The circuit assembly as claimed in Claim 10, further **characterized in that** said connecting seat unit (22) is further formed with a positioning keyway (221) in each of said receiving recesses (220), each of said mounting blocks (21) having a positioning key (215) provided thereon and slidably engaging said positioning keyway (221) in the respective one of said receiving recesses (220).

12. The circuit assembly as claimed in Claim 11, further **characterized in that** each of said mounting blocks (21) has parallel upper and lower plate portions (211, 212) spaced apart from each other, an intermediate plate portion (213) interconnecting said upper and lower plate portions (211, 212) , and an engaging rib (214) projecting from one of said upper and lower plate portions (211, 212) toward the other one of said upper and lower plate portions (211, 212), said end portion (31) of said flexible printed board (3) being formed with a pair of engaging holes (314), said engaging rib (214) of each of said mounting blocks (21) engaging a respective one of said engaging holes (314) formed in said end portion (31) of said flexible printed board (3) , said upper plate portion (211) of each of said mounting blocks (21) being provided with said positioning key (215) .

13. The circuit assembly as claimed in Claim 7, **characterized in that** said positioning unit (2') includes a pair of positioning blocks (21') mounted on said end portion (31) of said flexible printed board (3) and disposed on said circuit board (4' ) , said circuit board (4') being formed with a pair of positioning holes (23), each of said positioning blocks (21') having a positioning rib (215' ) engaging a respective one of said positioning holes (23) formed in said circuit board (4') for positioning said flexible printed board (3) on said circuit board (4').

14. The circuit assembly as claimed in Claim 13, further **characterized by** a hot-melt adhesive layer (24) between said flexible printed board (3) and said circuit board (4) so as to maintain electrical contact between said contact end portions (12) of said terminal pieces (1) and said contact pads (41) on said circuit board (4).

15. The circuit assembly as claimed in Claim 7, **characterized in that** said positioning unit includes first and second positioning posts (65, 66) with different cross-sections and provided on said flexible printed board (3"), said circuit board (4") being formed with first and second positioning holes (63, 64) that permit extension of a respective one of said first and second positioning posts (65, 66) therethrough.

16. The circuit assembly as claimed in Claim 16, further **characterized in that** each of said first and second positioning posts (65, 66) is formed with an enlarged end portion (650, 660) by a melting process after being extended through the respective one of said first and second positioning holes (63, 64), said enlarged end portion (650, 660) of each of said first and second positioningposts (65, 66) having a cross-section larger than that of the respective one of said first and second positioning holes (63, 64).
